# EUROPEAN PATENT SPECIFICATION

(11) **EP 2 555 052 B1**
(45) Date of publication and mention of the grant of the patent: **16.10.2024**
(21) Application number: 11765309.7
(22) Date of filing: 10.03.2011
(51) Int. Cl.: G03F 1/24, G03F 1/62, G03F 1/64

(54) **PHOTOMASK UNIT AND METHOD OF MANUFACTURING SAME**
FOTOMASKENEINHEIT UND HERSTELLUNGSVERFAHREN DAFÜR
UNITÉ DE PHOTOMASQUE ET SON PROCÉDÉ DE FABRICATION

(30) Priority: 02.04.2010 JP 2010086368
(43) Date of publication of application: 06.02.2013
(73) Proprietor: Shin-Etsu Chemical Co., Ltd., Tokyo 100-0004 (JP)
(72) Inventor: AKIYAMA Shoji, Annaka-shi Gunma 379-0195 (JP); KUBOTA Yoshihiro, Annaka-shi Gunma 379-0195 (JP)
(74) Representative: Herrmann, Uwe
(86) International application number: PCT/JP2011/055602
(87) International publication number: WO 2011/125407

(56) References cited:
- WO-A1-2008/007521
- JP-A- 2003 222 990
- JP-A- 2005 195 992
- JP-A- 2008 258 490
- JP-A- 2008 304 840
- JP-A- 2009 271 262
- JP-A- H10 144 594
- US-A1- 2008 024 751
- US-B1- 6 197 454
- US-B1- 6 317 479
- US-B1- 6 727 029
- US-B1- 7 473 501

## Description

### [FIELD OF THE INVENTION]

The present invention relates to a method for fabricating a photomask unit comprising a pellicle for lithography for use as a dustproof cover for an exposure stencil such as a photomask, a reticle (hereinafter collectively referred to as "photomask" in this specification) when a semiconductor device such as a large-scale integrated circuit, a very-large-scale integrated circuit (LSI), or a liquid crystal display panel is to be manufactured and a photomask, and particularly relates to a photomask unit and a method for fabricating a photomask unit suitable for exposing a photoresist film to light having an extremely short wavelength, thereby forming a microscopic pattern.

### [BACKGROUND OF THE INVENTION]

In the case of manufacturing a semiconductor device such as a large-scale integrated circuit (LSI), a very-large-scale integrated circuit, or a liquid crystal display panel, a photoresist film formed on a semiconductor wafer or a liquid crystal display panel mother substrate is irradiated with an exposure light via a photomask, whereby a pattern of the photomask is transferred onto the semiconductor device or the liquid crystal display panel mother substrate so that a pattern of the semiconductor device or the liquid crystal display panel is formed.

Therefore, in this case, when any foreign materials such as dust particles stuck to the photomask, reflect or absorb the an exposure light, so that not only does the pattern transferred onto the semiconductor wafer or the liquid crystal display panel mother substrate become deformed and the edge portion of the pattern become blurred but underlying surface is also blackened by soiling, whereby the size, quality, appearance of the semiconductor wafer or the liquid crystal display panel mother substrate are degraded so that the pattern of the photomask cannot be transferred onto the semiconductor wafer or the liquid crystal display panel mother substrate in the desired manner. As a result, the performance of the semiconductor wafer or the liquid crystal display panel mother substrate is lowered, whereby the yield ratio of the semiconductor wafer or the liquid crystal display panel mother substrate is inevitably reduced.

In order to solve these problems, the operation of exposing the semiconductor wafer or the liquid crystal display panel mother substrate is generally conducted in a clean room. However, even in such a case, since it is extremely difficult to completely prevent foreign materials from attaching to the surface of the photomask, the operation of exposing the semiconductor wafer or the liquid crystal display panel mother substrate is usually conducted with a dust proof cover, called a pellicle, and having a high transmittance with respect to the exposure light, mounted on the surface of the photomask.

Generally, a pellicle is manufactured by adhering a pellicle membrane made of a material having a high transmittance with respect to an exposure light, such as a cellulose based resin like nitrocellulose or cellulose acetate, fluoride resin, to one surface of a pellicle frame made of aluminum, stainless steel, polyethylene by applying a good solvent for the material of the pellicle membrane onto the one surface of the pellicle frame and adhering the air-dried pellicle membrane onto the one surface of the pellicle frame, or adhering the pellicle membrane onto the one surface of the pellicle frame using an adhesive agent such as acrylic resin, epoxy resin, fluorine resin, and then forming an agglutinant layer composed of polybutene resin, polyvinyl acetate resin, acrylic resin, silicone resin and adapted for adhering the photomask, and providing a release layer or a separator for protecting the agglutinant layer on the agglutinant layer (See Japanese Patent Application Laid Open No. 58-219023, U.S. Patent No.4861402, Japanese Patent Publication No. 63-27707 and Japanese Patent Application Laid Open No. 7-168345, for example).

In the case of mounting the thus constituted pellicle on the surface of the photomask and exposing the semiconductor wafer or the liquid crystal display panel mother substrate via the photomask, since foreign materials such as dust particles attach to the surface of the pellicle and do not directly attach to the surface of the photomask, it is possible to avoid the effect of foreign materials such as dust particles by projecting an exposure light in such a manner that the light is focused on the pattern formed on the photomask.

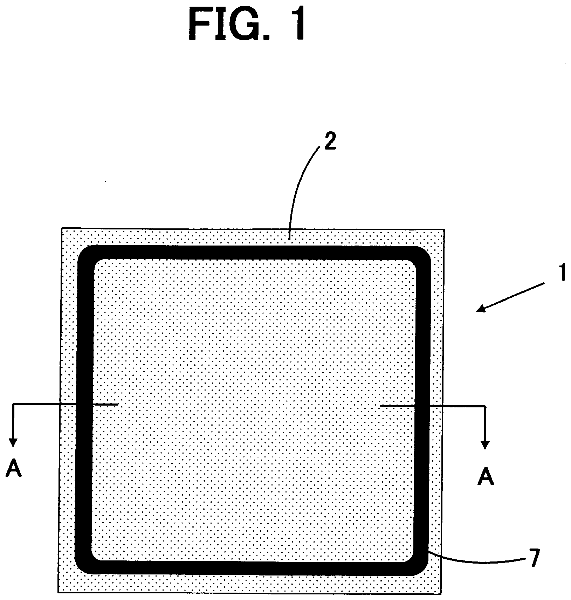

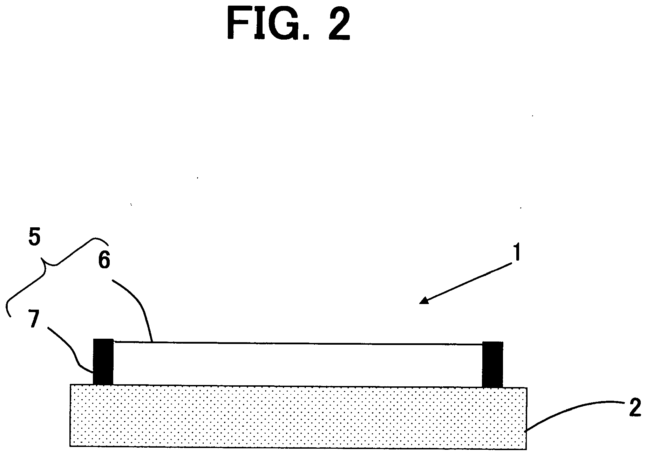

Figure 1 is a schematic plan view showing a conventional photomask unit including a photomask and a pellicle attached to the photomask and Figure 2 is a schematic cross sectional view taken along a line A-A in Figure 1.

As shown in Figures 1 and 2, a photomask unit 1 includes a photomask 2 and a pellicle 5 including a pellicle membrane 6 and a frame-like shaped pellicle frame 7 wherein a region of the pellicle membrane 6 in the vicinity of side portions thereof is adhered to the one surface of the pellicle frame 7 and the other surface of the pellicle frame 7 is fixed onto the surface of the photomask 2 by an agglutinant agent (not shown) comprising an organic material.

In this manner, since the surface of the photomask 2 is covered by a pellicle 5 as a dustproof cover, when the photoresist film formed on a semiconductor wafer or a liquid crystal display panel mother substrate is to be exposed, foreign materials such as dusts are attached onto the surface of the pellicle membrane 6 but the foreign materials are not directly attached onto the surface of the photomask 2. Therefore, if an exposure light is projected onto the photomask 2 in such a manner that the exposure light is focused onto a pattern formed on the photomask 2, it is possible to eliminate affection of the foreign materials such as dusts.

On the other hand, a semiconductor device and a liquid crystal display panel are recently required to have higher integration density and a more microscopic pattern and at present, it is put into practical use to form a microscopic pattern of about 45 nm on a photoresist film. It is possible to form a microscopic pattern of about 45 nm on a photoresist film by improving a conventional exposure technique using an eximer laser beam, for example, an immersion exposure technique including steps of filling a space between the semiconductor wafer or the liquid crystal display panel mother substrate and a projector lens with liquid such as ultrapure water and exposing the photoresist film to an argon fluoride (ArF) excimer laser beam, a double exposure technique.

However, it is required for a next-generation type semiconductor device or a next-generation type liquid crystal display panel to form a more microscopic pattern of 32 nm or smaller on a photoresist film and it is impossible to form a microscopic pattern of 32 nm or smaller on a photoresist film by improving a conventional exposure technique using an excimer laser beam. Thus, an EUV (Extreme Ultra Violet) exposure technique using an EUV (Extreme Ultra Violet) light whose dominant wavelength is 13.5 nm is considered a strong favorite as a method for forming a pattern of 32 nm or smaller.

In the case of forming a microscopic pattern of 32 nm or smaller on a photoresist film using the EUV exposure technique, it is necessary to solve technical problems of what light source is to be employed, what photoresist is to be employed, what pellicle is to be employed.

Among these problems, the development of a new light source and that of a new photoresist material have been advanced and a various proposals have been made. To the contrary, in connection with a pellicle which determines a yield ratio of a semiconductor device or a liquid crystal display panel, although silicon is proposed as a material having a high transmittance with respect to an EUV light, a various problems are left unsolved and what pellicle is to be employed remains a major obstacle to put the EUV exposure method into practical use. (See Shroff et al. "EUV pellicle Development for Mask Defect Control," Emerging Lithographic Technologies X, Proc of SPIE Vol.6151 615104-1(2006), United States Patent US 6,623,893 B1 and the like.)

### [PRIOR PUBLICATIONS]

### [PATENT PUBLICATIONS]

[PATENT PABLICATION 1]
   Japanese Patent Application Laid Open No. 58-219023
[PATENT PABLICATION 2]
   United States Patent No.4861402
[PATENT PABLICATION 3]
   Japanese Patent Publication No. 63-27707
[PATENT PABLICATION 4]
   Japanese Patent Application Laid Open No. 7-168345
[PATENT PABLICATION 5]
   United States Patent No. 6,623,893
[PATENT PABLICATION 6]
   United States Patent No. 6,197,454
JP 2008 258490 A illustrates a further relevant concept known in the field.

### [NON PATENT PUBLICATIONS]

[NON PATENT PUBLICATION 1]
Shroff et al. "EUV pellicle Development for Mask Defect Control," Emerging Lithographic Technologies X, Proc of SPIE Vol.6151 615104-1(2006)

### [DISCLOSURE OF THE INVENTION]

### [PROBLEMS TO BE SOLVED BY THE INVENTION]

In the case of forming a pattern on a photoresist film by exposing the photoresist film to an *i* ray (wavelength: 365 nm), a krypton fluoride (KrF) excimer laser beam (wavelength: 248 nm) or an argon fluoride (ArF) excimer laser beam (wavelength: 193 nm), a pellicle frame to which a pellicle membrane is attached is mounted on a photomask via an agglutinant agent containing an organic material. However, in the case of forming a microscopic pattern of 32 nm or smaller on a photoresist film using an EUV exposure technique, it is necessary to keep an exposure chamber to be vacuum. As a result, in the case of employing an agglutinant agent containing an organic material, since an outgas is generated from the agglutinant agent containing the organic material, it is difficult to mount a pellicle frame on a photomask using an agglutinant agent containing an organic material and it is necessary to avoid as practicably as possible using an agglutinant agent containing an organic material in the vicinity of a photomask.

Further, in order to form a microscopic pattern on the photoresist film using the EUV exposure technique, a photomask is required to have a high flatness but in the case of mounting a pellicle frame on a photomask using an agglutinant agent containing an organic material, the flatness of a photomask is lowered.

It is therefore an object of the present invention to provide a photomask unit comprising a pellicle and a photomask onto which the pellicle is attached, the photomask unit being suitable for forming a microscopic pattern of 32 nm or smaller on a photoresist film using an EUV exposure technique and being able to reliably prevent the flatness of a photomask from being lowered.

Another object of the present invention is to provide a method for fabricating a photomask unit comprising a pellicle and a photomask onto which the pellicle is attached, the photomask unit being suitable for forming a microscopic pattern of 32 nm or smaller on a photoresist film using an EUV exposure technique and being able to reliably prevent the flatness of a photomask from being lowered.

### [MEANS FOR SOLVING THE PROBLEMS]

The above objects of the present invention can be accomplished by a photomask unit comprising a pellicle membrane, a pellicle frame having a frame-like shape onto one surface of which a region of the pellicle membrane in the vicinity of side portions of the pellicle membrane is attached, a photomask, and a stage onto one surface of which the photomask and the pellicle frame are fixed, wherein the pellicle frame is fixed onto the stage at a region outside of a region of the stage onto which the photomask is fixed and the pellicle membrane through which exposure light transmits is provided to cover an entire region of one of the openings formed by the pellicle frame.

According to the present invention, since the pellicle frame onto the one surface of which the region of the pellicle membrane in the vicinity of side portions of the pellicle membrane is attached is fixed onto the stage at a region outside of a region of the stage onto which the photomask is fixed and the region of the stage onto which the pellicle frame is fixed is apart from an exposure pattern portion where the photomask formed with a pattern and exposed to light is located, when a microscopic pattern of 32 nm or smaller is formed on a photoresist film using the EUV exposure technique while keeping an exposure chamber to be vacuum, even if an outgas is generated from the agglutinant agent containing an organic material, it is possible to efficiently prevent the exposure operation of the photoresist film formed on a semiconductor device or the liquid crystal display panel from being subject to adverse effect.

Further, according to the present invention, since the pellicle frame is fixed onto the stage at a region outside of a region of the stage onto which the photomask is fixed and is not fixed onto the photomask unlike the conventional photomask unit, it is possible to reliably prevent the flatness of the photomask from being lowered.

Not being part of the present invention, it is preferable for the pellicle frame to be made of metal.

In a preferred aspect of the present invention, not being part of the present invention, the pellicle frame is fixed by an electrostatic chuck onto the one surface of the stage.

According to this preferred aspect of the present invention, not being part of the present invention, since the pellicle frame is fixed by an electrostatic chuck onto the one surface of the stage, it is possible to reliably prevent an outgas from being generated from a portion where the pellicle frame is fixed on the stage, when a microscopic pattern of 32 nm or smaller is formed on a photoresist film using the EUV exposure technique while keeping an exposure chamber to be vacuum.

In another preferred aspect of the present invention, not being part of the present invention, the pellicle frame is fixed by a mechanical means onto the one surface of the stage.

According to this preferred aspect of the present invention, not being part of the present invention, the pellicle frame is fixed by a mechanical means such as clamps, threads onto the one surface of the stage, it is possible to reliably prevent an outgas from being generated from a portion where the pellicle frame is fixed on the stage, when a microscopic pattern of 32 nm or smaller is formed on a photoresist film using the EUV exposure technique while keeping an exposure chamber to be vacuum.

In another preferred aspect of the present invention, not being part of the present invention, the pellicle frame is fixed by an agglutinant agent onto the one surface of the stage.

The above objects of the present invention can be also accomplished by a method for fabricating a photomask unit comprising a pellicle membrane, a pellicle frame having a frame-like shape and onto the one surface of which a region of the pellicle membrane in the vicinity of side portions of the pellicle membrane is attached, a photomask and a stage onto the one surface of which the photomask and the pellicle frame are to be fixed, the method for fabricating a photomask unit comprising steps of fixing the photomask onto the one surface of the stage and fixing the other surface of the pellicle frame onto the one surface of the stage at a region outside of a region of the one surface of the stage onto which the photomask is fixed and the pellicle membrane through which exposure light transmits is provided to cover an entire region of one of the openings formed by the pellicle frame.

According to the present invention, since the pellicle frame onto the one surface of which the region of the pellicle membrane in the vicinity of side portions of the pellicle membrane is attached is fixed onto the stage at a region outside of a portion of the stage onto which the photomask is fixed and the portion of the stage onto which the pellicle frame is fixed is apart from an exposure pattern portion where the photomask formed with a pattern and exposed to light is located, when a microscopic pattern of 32 nm or smaller is formed on a photoresist film using the EUV exposure technique while keeping an exposure chamber to be vacuum, even if an outgas is generated from the agglutinant agent containing an organic material, it is possible to efficiently prevent the exposure operation of the photoresist film formed on a semiconductor device or a liquid crystal display panel from being subject to adverse effect.

Further, according to the present invention, since the pellicle frame is fixed onto the stage at a region outside of a region of the stage onto which the photomask is fixed and is not fixed onto the photomask unlike the conventional photomask unit, it is possible to reliably prevent the flatness of the photomask from being lowered.

In a preferred aspect of the present invention, not being part of the present invention, the pellicle frame is fixed by an electrostatic chuck onto the one surface of the stage.

According to this preferred aspect of the present invention, not being part of the present invention, the pellicle frame is fixed by an electrostatic chuck onto the one surface of the stage, it is possible to reliably prevent an outgas from being generated from a portion where the pellicle frame is fixed onto the stage, when a microscopic pattern of 32 nm or smaller is formed on a photoresist film using the EUV exposure technique while keeping an exposure chamber to be vacuum.

In another preferred aspect of the present invention, not being part of the present invention, the pellicle frame is fixed by a mechanical means onto the one surface of the stage.

According to this preferred aspect of the present invention, not being part of the present invention, the pellicle frame is fixed by a mechanical means such as a clamp, a thread onto the one surface of the stage, it is possible to reliably prevent an outgas from being generated from a portion where the pellicle frame is fixed onto the stage, when a microscopic pattern of 32 nm or smaller is formed on a photoresist film using the EUV exposure technique while keeping an exposure chamber to be vacuum.

In another preferred aspect of the present invention, not being part of the present invention, the pellicle frame is fixed by an agglutinant agent onto the one surface of the stage.

The above and other objects and features of the present invention will become apparent from the following description made with reference to the accompanying drawings.

### [TECHNICAL ADVANTAGES OF THE INVENTION]

According to the present invention, it is possible to provide a photomask unit comprising a photomask and a pellicle attached onto the photomask, the photomask unit being suitable for forming a microscopic pattern of 32 nm or smaller on a photoresist film using an EUV exposure technique and being able to reliably prevent the flatness of a photomask from being lowered.

Further, according to the present invention, it is possible to provide a method for fabricating a photomask unit comprising a photomask and a pellicle attached onto the photomask, the photomask unit being suitable for forming a microscopic pattern of 32 nm or smaller on a photoresist film using an EUV exposure technique and being able to reliably prevent the flatness of a photomask from being lowered.

### [BRIEF DESCRIPTION OF THE DRAWINGS]

[Figure 1]
   Figure 1 is a schematic plan view showing a conventional photomask unit including a photomask and a pellicle attached onto the photomask.
[Figure 2]
   Figure 2 is a schematic cross sectional view taken along a line A-A in Figure 1.
[Figure 3]

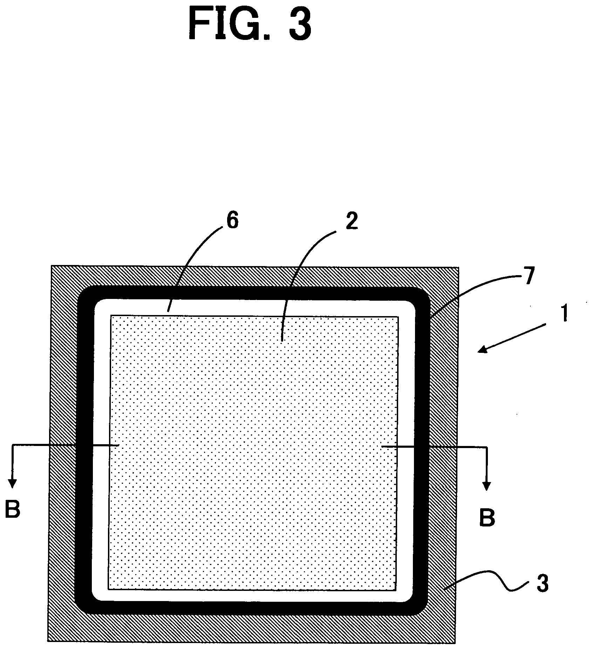

   Figure 3 is a schematic perspective plan view showing a photomask unit including a photomask and a pellicle attached onto the photomask, which is a preferred embodiment of the present invention, not being part of the present invention.
[Figure 4]

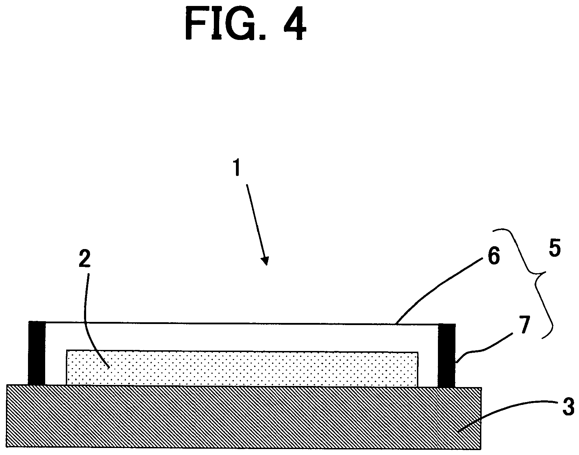

   Figure 4 is a schematic cross sectional view taken along a line B-B in Figure 3.
[Figure 5]

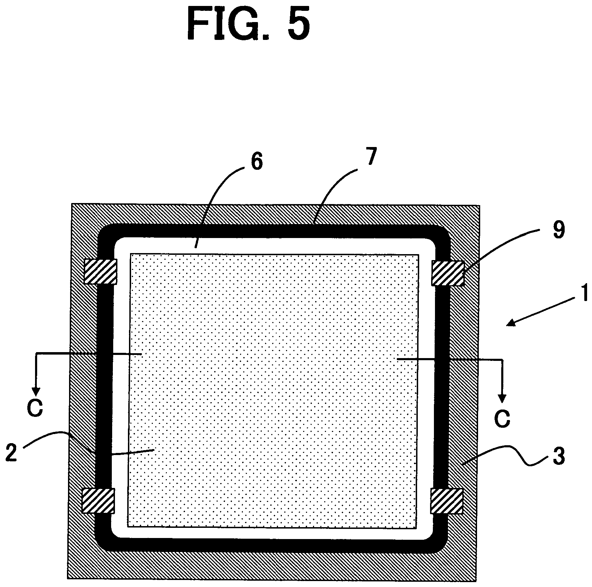

   Figure 5 is a schematic perspective plan view showing a photomask unit including a pellicle attached onto the photomask, which is another preferred embodiment of the present invention, not being part of the present invention.
[Figure 6]

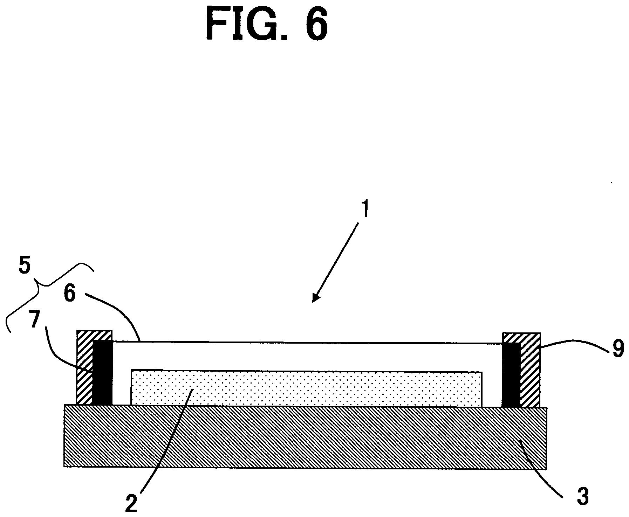

   Figure 6 is a schematic cross sectional view taken along a line C-C in Figure 5.

### [DESCRIPTION OF THE PREFERRED EMBODIMENTS]

Figure 3 is a schematic perspective plan view showing a photomask unit including a photomask and a pellicle attached onto the photomask, which is a preferred embodiment of the present invention, not being part of the present invention, and Figure 4 is a schematic cross sectional view taken along a line B-B in Figure 3.

As shown in Figures 3 and 4, a photomask unit 1 according to this preferred embodiment includes a photomask 2, a photomask stage 3 onto which the photomask 2 is to be fixed, a pellicle membrane 6 and a pellicle frame 7 having a frame-like shape and attached with the pellicle membrane 6 on the one surface thereof, and a pellicle 5 is constituted by the pellicle membrane 6 and the pellicle frame 7. In this embodiment, the pellicle frame 7 is made of aluminum.

As shown in Figures 3 and 4, the size of the pellicle frame 7 is larger than that of the photomask 2 and the pellicle frame 7 is fixed onto the photomask stage 3 at a region outside of a region of the photomask stage 3 onto which the photomask 2 is fixed. Thus, the photomask 2 is accommodated in a closed space defined by the pellicle membrane 6 and the pellicle frame 7.

In this embodiment, the photomask 2 is fixed by an electrostatic chuck (not shown) onto the photomask stage 3.

On the other hand, in this preferred embodiment, although the pellicle frame 7 is also fixed by an electrostatic chuck onto the photomask stage 3, the pellicle frame 7 may be fixed onto the photomask stage 3 using a mechanical means such as a clamp, a thread. Further, the pellicle frame 7 may be fixed onto the photomask stage 3 using an agglutinant agent containing an organic material such as a silicone agglutinant agent.

The thus fabricated photomask unit 1 is set in an exposure chamber (not shown). Then, an exposure light is projected via the photomask 2 onto a photoresist film coated on a semiconductor wafer or a liquid crystal display panel mother substrate and a pattern of the photomask 2 is transferred onto the photoresist film, thereby forming a pattern of a semiconductor wafer or the liquid crystal display panel mother substrate.

In this preferred embodiment, the photomask 2 and the pellicle frame 7 are fixed onto the photomask stage 3 by the electrostatic chuck and the size of the pellicle frame 7 is larger than that of the photomask 2. Thus, the pellicle frame 7 is fixed by an electrostatic chuck onto the photomask stage 3 at a region outside of a region of the photomask stage 3 onto which the photomask 2 is fixed. Therefore, even when the photoresist film of the semiconductor wafer or the liquid crystal display panel mother substrate (not shown) is exposed to an EUV light while keeping an exposure chamber to be vacuum, an outgas cannot be generated. Accordingly, even in the case of forming a microscopic pattern of 32 nm or smaller on the photoresist film while keeping an exposure chamber to be vacuum, it is possible to improve the yield ratio of the semiconductor device or the liquid crystal display panel.

Further, according to this preferred embodiment, since the pellicle frame 7 is fixed onto the photomask stage 3 at a region outside of a region of the photomask stage 3 onto which the photomask 2 is fixed and is not fixed onto the surface of the photomask 2 unlike the conventional photomask unit, it is possible to suppress the lowering of the flatness of the photomask 2 caused by attaching the pellicle 5 to the minimum.

Figure 5 is a schematic perspective plan view showing a photomask unit including a photomask and a pellicle attached to the photomask stage, which is another preferred embodiment of the present invention, not being part of the present invention, and Figure 6 is a schematic cross sectional view taken along a line C-C in Figure 5.

As shown in Figures 5 and 6, similarly to the photomask unit 1 according to the previous embodiment, a photomask unit 1 according to this preferred embodiment includes a photomask 2, a photomask stage 3 onto the one surface of which the photomask 2 is to be fixed, a pellicle membrane 6 and a frame-like shaped pellicle frame 7 onto which the pellicle membrane 6 is attached, and a pellicle 5 is constituted by the pellicle membrane 6 and the pellicle frame 7. In this embodiment, the pellicle frame 7 is also made of aluminum.

As shown in Figures 5 and 6, the size of the pellicle frame 7 is larger than that of the photomask 2 and the pellicle frame 7 is fixed onto the photomask stage 3 at a region outside of a region of the photomask stage 3 onto which the photomask 2 is fixed.

Like the previous embodiment, in this embodiment of the present invention, not being part of the present invention, the photomask 2 is fixed by an electrostatic chuck onto the photomask stage 3.

In the photomask unit 1 according to this preferred embodiment, as shown in Figures 5 and 6, the pellicle frame 7 is fixed onto the photomask stage 3 by a mechanical clamp 9.

The thus fabricated photomask unit 1 is set in an exposure chamber (not shown). Then, an exposure light is projected via the photomask 2 onto a photoresist film formed on a semiconductor wafer or a liquid crystal display panel mother substrate and a pattern of the photomask 2 is transferred onto the photoresist film, thereby forming a pattern of a semiconductor wafer or a liquid crystal display panel mother substrate.

In this preferred embodiment, the size of the pellicle frame 7 is larger than that of the photomask 2 and the pellicle frame 7 is fixed by mechanical clamp 9 onto the photomask stage 3 at a region outside of a region of the photomask stage 3 onto which the photomask 2 is fixed. Therefore, even when the photoresist film of the semiconductor wafer or the liquid crystal display panel mother substrate (not shown) is exposed to an EUV light while keeping an exposure chamber to be vacuum, an outgas cannot be generated. Thus, even in the case of forming a microscopic pattern of 32 nm or smaller while keeping an exposure chamber to be vacuum, it is possible to improve the yield ratio of the semiconductor device or the liquid crystal display panel.

Further, according to this preferred embodiment, since the pellicle frame 7 is fixed onto the photomask stage 3 at a region outside of a region onto which the photomask 2 is fixed and is not fixed onto the surface of the photomask 2 unlike the conventional photomask unit, it is possible to suppress the lowering of the flatness of the photomask 2 caused by attaching the pellicle 5 to the minimum.

Hereinafter, working examples and a comparative example will be set out in order to further clarify the advantages of the present invention.

### [WORKING EXAMPLE 1]

A square shaped photomask substrate whose one side length was 152 mm and thickness was 6 mm and which was made of quartz was prepared and a chromium film was evaporated on one surface of the photomask substrate and the other surface of the photomask substrate was fixed onto a photomask stage by an electrostatic chuck.

Then, a rectangle shaped pellicle frame whose inner frame length was 160 mm, outer frame length was 166 mm and wall thickness was 3 mm and which was made of aluminum was prepared and the pellicle frame was fixed by an electrostatic chuck onto the photomask stage at a region outside of a region of the photomask stage onto which the photomask substrate was fixed, thereby fabricating a photomask unit.

Next, in order to simulate the behavior of the photomask unit when it would be subjected to a high speed scanning operation in an actual manufacturing line, the photomask stage was vibrated for ten minutes so that acceleration of about 5G was applied to the photomask stage. As a result, the displacement of the pellicle frame from its initial position was not observed although the pellicle frame was fixed onto the photomask stage only by the electrostatic chuck.

Further, an EUV light having a wavelength of 13.5 nm was intermittently projected onto the photomask unit for three minutes in total and the reflection ratio of the photomask was measured after the irradiation with the EUV light. The thus measured reflection ratio of the photomask was compared with the reflection ratio of the photomask before the irradiation with the EUV light. As a result, the reduction in reflection ratio of the photomask was not observed.

### [WORKING EXAMPLE 2]

A square shaped photomask substrate whose one side length was 152 mm and thickness was 6 mm and which was made of quartz was prepared and a chromium film was evaporated on the one surface of the photomask substrate and the other surface of the photomask substrate was fixed onto a photomask stage by an electrostatic chuck.

Then, a rectangle shaped pellicle frame made of aluminum whose inner frame length was 160 mm, outer frame length was 166 mm and wall thickness was 3 mm was prepared and the pellicle frame was fixed by a mechanical clamp onto the photomask stage at a region outside of a region of the photomask stage onto which the photomask substrate was fixed, thereby fabricating a photomask unit.

Next, in order to simulate the behavior of the photomask unit when it would be subjected to a high speed scanning operation in an actual manufacturing line, the photomask stage was vibrated for ten minutes so that acceleration of about 5G was applied to the photomask stage. As a result, the displacement of the pellicle frame from its initial position was not observed although the pellicle frame was fixed onto the photomask stage only by the mechanical clamp.

Further, an EUV light having a wavelength of 13.5 nm was intermittently projected onto the photomask unit for three minutes in total and the reflection ratio of the photomask was measured after the irradiation with the EUV light. The thus measured reflection ratio of the photomask was compared with the reflection ratio of the photomask before the irradiation with the EUV light. As a result, the reduction in reflection ratio of the photomask was not observed.

### [WORKING EXAMPLE 3]

A square shaped photomask substrate whose one side length was 152 mm and thickness was 6 mm and which was made of quartz was prepared and a chromium film was evaporated on the one surface of the photomask substrate and the other surface of the photomask substrate was fixed onto a photomask stage by an electrostatic chuck.

Then, a rectangle shaped pellicle frame whose inner frame length was 160 mm, outer frame length was 166 mm and wall thickness was 3 mm and which was made of aluminum was prepared and the pellicle frame was fixed by a silicone agglutinant agent onto the photomask stage at a region outside of a region of the photomask stage onto which the photomask substrate, thereby fabricating a photomask unit.

Next, in order to simulate the behavior of the photomask unit when it would be subjected to a high speed scanning operation in an actual manufacturing line, the photomask stage was vibrated for ten minutes so that acceleration of about 5G was applied to the photomask stage. As a result, the displacement of the pellicle frame from its initial position was not observed although the pellicle frame was fixed onto the photomask stage only by the silicone agglutinant.

Further, an EUV light having a wavelength of 13.5 nm was intermittently projected onto the photomask unit for three minutes in total and the reflection ratio of the photomask was measured after the irradiation with the EUV light. The thus measured reflection ratio of the photomask was compared with the reflection ratio of the photomask before the irradiation with the EUV light. As a result, the reduction in reflection ratio of the photomask was not observed.

### [COMPARATIVE EXAMPLE]

A square shaped photomask substrate whose one side length was 152 mm and thickness was 6 mm and which was made of quartz was prepared and a chromium film was evaporated on the one surface of the photomask substrate and the other surface of the photomask substrate was fixed onto a photomask stage by an electrostatic chuck.

Then, a rectangle shaped pellicle frame whose inner frame length was 143 mm, outer frame length was 149 mm and wall thickness was 3 mm and which was made of aluminum was prepared and the pellicle frame was fixed by a silicone agglutinant agent onto the photomask substrate, thereby fabricating a photomask unit.

Next, in order to simulate the behavior of the photomask unit when it would be subjected to a high speed scanning operation in an actual manufacturing line, the photomask stage was vibrated for ten minutes so that acceleration of about 5G was applied to the photomask stage. As a result, the displacement of the pellicle frame from its initial position was not observed.

Further, an EUV light having a wavelength of 13.5 nm was intermittently projected onto the photomask unit for three minutes in total and the reflection ratio of the photomask was measured after the irradiation with the EUV light. The thus measured reflection ratio of the photomask was compared with the reflection ratio of the photomask before the irradiation with the EUV light. As a result, it was observed that the reflection ratio of the photomask was reduced by about 0.5 % by the irradiation with the EUV light. It would be reasonable to understand that this reduction in the reflection ratio of the photomask was caused by outgas generated from the silicone agglutinant agent used for fixing the pellicle frame.

The present invention has thus been shown and described with reference to the preferred embodiments and the working examples. However, it should be noted that the present invention is in no way limited to the details of the described arrangement but changes and modifications may be made without departing from the scope of the appended claims.

For example, the pellicle frame 7 is fixed onto the photomask stage 3 by the electrostatic chuck in the preferred embodiment shown in Figures 3 and 4 and the pellicle frame 7 is fixed onto the photomask stage 3 by the mechanical clamp 9 in the preferred embodiment shown in Figures 5 and 6. However, it is not absolutely necessary to fix the pellicle frame 7 onto the photomask stage 3 by the electrostatic chuck or the mechanical clamp 9 and the pellicle frame 7 may be fixed onto the photomask stage 3 by an agglutinant agent containing an organic material such as a silicone agglutinant agent. According to the present invention, even in the case of fixing the pellicle frame 7 onto the photomask stage 3 using an agglutinant agent containing an organic material such as a silicone agglutinant agent, since the pellicle frame 7 is fixed onto the photomask stage 3 at a region outside of a region of the photomask stage 3 onto which the photomask 2 is fixed, when the photoresist film of a semiconductor wafer or a liquid crystal display panel mother substrate (not shown) is exposed to an EUV light while keeping an exposure chamber to be vacuum, even if an outgas is generated from the agglutinant agent containing an organic material, it is possible to suppress the adverse effect of the outgas to the minimum.

Further, although the pellicle frame 7 is fixed onto the photomask stage 3 by the mechanical clamp 9 in the preferred embodiment shown in Figures 5 and 6, in the case of fixing the pellicle frame 7 onto the photomask stage 3 by a mechanical means, it is not absolutely necessary to fix the pellicle frame 7 onto the photomask stage 3 using the mechanical clamp 9 but the pellicle frame 7 may be fixed onto the photomask stage 3 using other mechanical means such as a thread.

Moreover, in the above described preferred embodiments and Working Examples, although the pellicle frame 7 made of aluminum was used, it is not absolutely necessary to use a pellicle frame 7 made of aluminum but it is possible to use a pellicle frame 7 made of other metal such as stainless steel instead of aluminum. Further, it is not absolutely necessary for a pellicle frame 7 to be made of metal but it is possible to make a pellicle frame 7 of plastics such as polyethylene.

Furthermore, in Working Examples, although the photomask substrate having a square shape and the pellicle frame having a rectangle shape were used, it is not absolutely necessary for each of the photomask substrates to have a square shape and it is not absolutely necessary for each of the pellicle frames to have a rectangle shape. It is possible to use the photomask substrate or the pellicle frames having an arbitrary shape as occasion demands.

### [Explanation of Reference Numerals]

- 1: a photomask unit
- 2: a photomask
- 3: a photomask stage
- 5: a pellicle
- 6: a pellicle membrane
- 7: a pellicle frame
- 9: a mechanical clamp

## Claims

1. A photomask unit (1) comprising a pellicle membrane (6), a pellicle fram (7) having a frame-like shape onto one surface of which a region of the pellicle membrane in the vicinity of side portions thereof is fixed, a photomask (2), and a stage (3) onto one surface of which the photomask and the pellicle frame are fixed, wherein
the pellicle frame is fixed onto the stage at a region outside of a region of the stage onto which the photomask is fixed and the pellicle membrane through which exposure light transmits is provided to cover an entire region of one of the openings formed by the pellicle frame.

2. A photomask unit in accordance with Claim 1, wherein the pellicle frame is made of metal.

3. A photomask unit in accordance with Claim 1 or 2, wherein the pellicle frame is fixed by an electrostatic chuck onto the one surface of the stage.

4. A photomask unit in accordance with Claim 1 or 2, wherein the pellicle frame is fixed by a mechanical means onto the one surface of the stage.

5. A photomask unit in accordance with Claim 1 or 2, wherein the pellicle frame is fixed using an agglutinant agent onto the one surface of the stage.

6. A method for fabricating a photomask unit (1) comprising a pellicle membrane (6), a pellicle frame (7) having a frame-like shape onto one surface of which a region of the pellicle membrane in the vicinity of side portions thereof is attached, a photomask (2) and a stage (3) onto one surface of which the photomask and the pellicle frame are to be fixed;
the method for fabricating a photomask unit comprising steps of fixing the photomask onto the one surface of the stage and fixing the other surface of the pellicle frame onto the one surface of the stage at a region outside of a region of the one surface of the stage onto which the photomask is fixed and the pellicle membrane through which exposure light transmits is provided to cover an entire region of one of the openings formed by the pellicle frame.

7. A method for fabricating a photomask unit in accordance with Claim 6, wherein the pellicle frame is made of metal.

8. A method for fabricating a photomask unit in accordance with Claim 6 or 7, wherein the pellicle frame is fixed by an electrostatic chuck onto the one surface of the stage.

9. A method for fabricating a photomask unit in accordance with Claim 6 or 7, wherein the pellicle frame is fixed by a mechanical means onto the one surface of the stage.

10. A method for fabricating a photomask unit in accordance with Claim 6 or 7, wherein the pellicle frame is fixed by an agglutinant agent onto the one surface of the stage.

## Patentansprüche

1. Fotomaskeneinheit (1) mit einer Pellikelmembran (6), einem Pellikelrahmen (7) mit einer rahmenartigen Form, auf dessen einer Oberfläche ein Bereich der Pellikelmembran in der Nähe ihrer Seitenabschnitte befestigt ist, einer Fotomaske (2) und einem Objekttisch (3), auf dessen einer Oberfläche die Fotomaske und der Pellikelrahmen befestigt sind, wobei
der Pellikelrahmen auf dem Objekttisch in einem Bereich außerhalb eines Bereichs des Objekttischs befestigt ist, auf dem die Fotomaske befestigt ist, und die Pellikelmembran, durch die das Belichtungslicht hindurchtritt, dazu vorgesehen ist, einen gesamten Bereich einer der von dem Pellikelrahmen gebildeten Öffnungen zu bedecken.

2. Fotomaskeneinheit nach Anspruch 1, wobei der Pellikelrahmen aus Metall besteht.

3. Fotomaskeneinheit nach Anspruch 1 oder 2, wobei der Pellikelrahmen durch eine elektrostatische Spannvorrichtung auf der einen Oberfläche des Objekttisches befestigt ist.

4. Fotomaskeneinheit nach Anspruch 1 oder 2, wobei der Pellikelrahmen durch ein mechanisches Mittel an der einen Oberfläche des Objekttisches befestigt ist.

5. Fotomaskeneinheit nach Anspruch 1 oder 2, wobei der Pellikelrahmen unter Verwendung eines Klebemittels auf der einen Oberfläche des Objekttisches befestigt ist.

6. Verfahren zur Herstellung einer Fotomaskeneinheit (1) mit einer Pellikelmembran (6), einem Pellikelrahmen (7) mit einer rahmenartigen Form, auf dessen einer Oberfläche ein Bereich der Pellikelmembran in der Nähe ihrer Seitenabschnitte befestigt ist, einer Fotomaske (2) und einem Objekttisch (3), auf dessen einer Oberfläche die Fotomaske und der Pellikelrahmen zu befestigen sind;
wobei das Verfahren zur Herstellung einer Fotomaskeneinheit die Schritte des Befestigens der Fotomaske auf der einen Oberfläche des Objekttisches und des Befestigens der anderen Oberfläche des Pellikelrahmens auf der einen Oberfläche des Objekttisches in einem Bereich außerhalb eines Bereichs der einen Oberfläche des Objekttisches, auf dem die Fotomaske befestigt ist, umfasst, und die Pellikelmembran, durch die das Belichtungslicht hindurchtritt, dazu vorgesehen ist, einen gesamten Bereich einer der durch den Pellikelrahmen gebildeten Öffnungen zu bedecken.

7. Verfahren zur Herstellung einer Fotomaskeneinheit nach Anspruch 6, wobei der Pellikelrahmen aus Metall besteht.

8. Verfahren zur Herstellung einer Fotomaskeneinheit nach Anspruch 6 oder 7, wobei der Pellikelrahmen durch eine elektrostatische Spannvorrichtung auf der einen Oberfläche des Objekttisches befestigt ist.

9. Verfahren zur Herstellung einer Fotomaskeneinheit nach Anspruch 6 oder 7, wobei der Pellikelrahmen durch ein mechanisches Mittel an der einen Oberfläche des Objekttisches befestigt ist.

10. Verfahren zur Herstellung einer Fotomaskeneinheit nach Anspruch 6 oder 7, wobei der Pellikelrahmen durch ein Klebemittel auf der einen Oberfläche des Objekttisches befestigt ist.

## Revendications

1. Unité de photomasque (1) comprenant une membrane pelliculaire (6), un cadre de pellicule (7) ayant une forme de cadre sur une surface de laquelle une région de la membrane pelliculaire à proximité de ses parties latérales est fixée, un photomasque (2), et une platine (3) sur une surface de laquelle le photomasque et le cadre de pellicule sont fixés, dans laquelle
le cadre de pellicule est fixé sur la platine dans une région située en dehors de la région de la platine sur laquelle le photomasque est fixé et la membrane pelliculaire à travers laquelle la lumière d'exposition est transmise est prévue pour couvrir une région entière de l'une des ouvertures formées par le cadre de pellicule.

2. Unité de photomasque selon la revendication 1, dans laquelle le cadre de pellicule est fait de métal.

3. Unité de photomasque selon la revendication 1 ou 2, dans laquelle le cadre de pellicule est fixé par un mandrin électrostatique sur l'une des surfaces de la platine.

4. Unité de photomasque selon la revendication 1 ou 2, dans laquelle le cadre de pellicule est fixé par un moyen mécanique sur l'une des surfaces de la platine.

5. Unité de photomasque selon la revendication 1 ou 2, dans laquelle le cadre de pellicule est fixé en utilisant un agent agglutinant sur l'une des surfaces de la platine.

6. Procédé de fabrication d'une unité de photomasque (1) comprenant une membrane pelliculaire (6), un cadre de pellicule (7) ayant une forme de cadre sur une surface de laquelle une région de la membrane pelliculaire à proximité de ses parties latérales est fixée, un photomasque (2), et une platine (3) sur une surface de laquelle le photomasque et le cadre de pellicule peuvent être fixés ;
le procédé de fabrication d'une unité de photomasque comprenant les étapes de fixation du photomasque sur l'une des surfaces de la platine et de fixation de l'autre surface du cadre de pellicule sur l'une des surfaces de la platine dans une région en dehors d'une région de l'une des surfaces de la platine sur laquelle le photomasque est fixé et la membrane pelliculaire à travers laquelle la lumière d'exposition est transmise est fournie pour couvrir une région entière de l'une des ouvertures formées par le cadre de pellicule.

7. Procédé de fabrication d'une unité de photomasque selon la revendication 6, dans laquelle le cadre de pellicule est fait de métal.

8. Procédé de fabrication d'une unité de photomasque selon la revendication 6 ou 7, dans laquelle le cadre de pellicule est fixé par un mandrin électrostatique sur l'une des surfaces de la platine.

9. Procédé de fabrication d'une unité de photomasque selon la revendication 6 ou 7, dans laquelle le cadre de pellicule est fixé par un moyen mécanique sur l'une des surfaces de la platine.

10. Procédé de fabrication d'une unité de photomasque selon la revendication 6 ou 7, dans laquelle le cadre de pellicule est fixé par un agent agglutinant sur l'une des surfaces de la platine.
